# EUROPEAN PATENT SPECIFICATION

(11) **EP 2 511 043 B1**
(45) Date of publication and mention of the grant of the patent: **11.07.2018**
(21) Application number: 10835926.6
(22) Date of filing: 06.12.2010
(51) Int. Cl.: H05K 3/34, B23K 35/36, B23K 35/362, C22C 13/00, B23K 35/02

(54) **FLUX FOR SOLDER PASTE, AND SOLDER PASTE**
FLUSSMITTEL FÜR EINE LÖTPASTE UND LÖTPASTE
FLUX POUR PÂTE À BRASER ET PÂTE À BRASER

(30) Priority: 08.12.2009 JP 2009278210
(43) Date of publication of application: 17.10.2012
(73) Proprietor: Arakawa Chemical Industries, Ltd., Osaka-shi Osaka 541-0046 (JP); TOYOTA JIDOSHA KABUSHIKI KAISHA, Toyota-shi, Aichi-ken, 471-8571 (JP); Denso Corporation, Kariya-city Aichi 448-8661 (JP); Fujitsu Ten Limited, Hyogo 652-8510 (JP); Koki Company Limited, Tokyo 120-0026 (JP); Harima Chemicals, Inc., Hyogo 675-0019 (JP)
(72) Inventor: IWAMURA, Eiji, Osaka-shi Osaka 538-0053 (JP); GOTOH, Kazushi, Osaka-shi Osaka 538-0053 (JP); NAGASAKA, Shinsuke, Osaka-shi Osaka 538-0053 (JP); YOSHIOKA, Takayasu, Toyota-shi Aichi 471-8571 (JP); UTSUNO, Masayoshi, Toyota-shi Aichi 471-8571 (JP); NAKAMURA, Atsuo, Toyota-shi Aichi 471-8571 (JP); OKOCHI, Teruo, Toyota-shi Aichi 471-8571 (JP); SANJI, Masaki, Kariya-city Aichi 448-8661 (JP); SUKEKAWA, Takuji, Kariya-city Aichi 448-8661 (JP); IKEDO, Kenshi, Kobe-shi Hyogo 652-8510 (JP); ANDOH, Yoshiyuki, Kobe-shi Hyogo 652-8510 (JP); SHIRAI, Takeshi, Tokyo 120-0026 (JP); MORI, Kimiaki, Tokyo 120-0026 (JP); WADA, Rie, Tokyo 120-0026 (JP); NAKANISHI, Kensuke, Kakogawa-shi Hyogo 675-0019 (JP); AIHARA, Masami, Kakogawa-shi Hyogo 675-0019 (JP); KUMAMOTO, Seishi, Kakogawa-shi Hyogo 675-0019 (JP)
(74) Representative: Wächter, Jochen
(86) International application number: PCT/JP2010/071808
(87) International publication number: WO 2011/071006

(56) References cited:
- EP-A1- 1 260 303
- EP-A1- 1 897 652
- WO-A1-2009/104693
- JP-A- 2007 222 932
- JP-A- 2008 062 242
- JP-A- 2008 110 369
- JP-A- 2008 110 369
- JP-A- 2008 110 370
- US-A- 5 907 007

## Description

The present invention relates to a flux for a solder paste and a solder paste.

### BACKGROUND ART

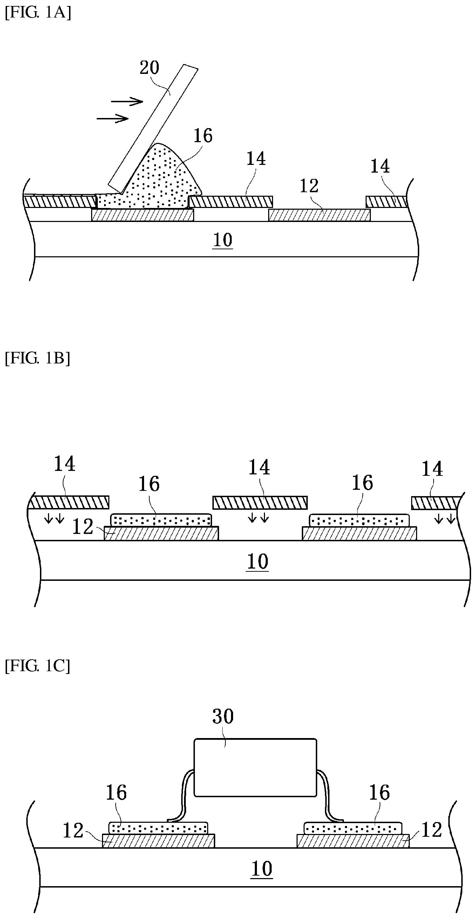

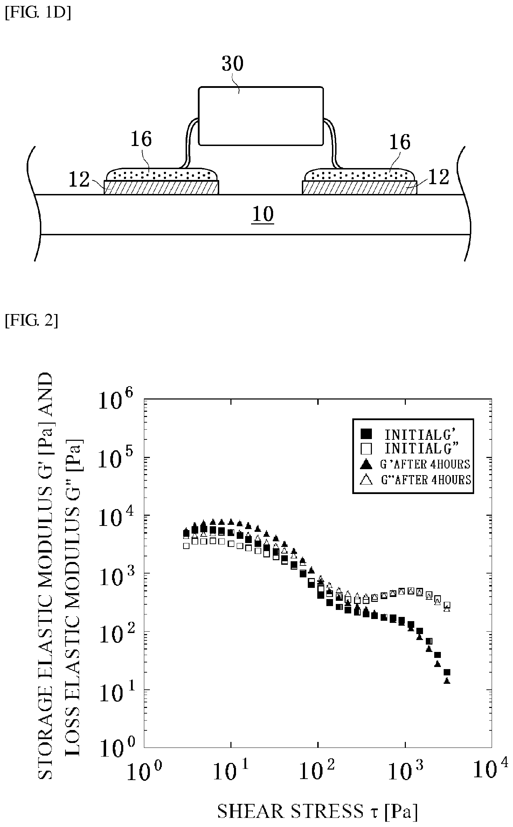

A screen printing process in a soldering process using generally a solder paste is divided principally into four steps shown in Fig. 1A to 1D. First, an appropriate amount of a solder paste 16 is fed onto so called a metal stencil mask plate 14 that is open at a side above an electrode 12 placed on a substrate 10 to be soldered. Thereafter, the solder paste 16 is inserted into the opening by a urethane or metal spatula-shaped jig called a squeegee 20 (Fig. 1A). Consequently, the solder paste 16 is transferred and coated onto the electrode 12 (Fig. 1B). Subsequently, various kinds of electronic components 30 are mounted (Fig. 1C). Thereafter, a solder metal is melted through a heating step called a reflow, whereby the electronic components 30 and the electrode 12 on the substrate 10 are bonded together (Fig. 1D).

The solder paste is usually a viscoelastic substance having solid and liquid natures. The solder paste exhibits a solid nature when standing on a stencil mask. However, the solder paste is fluidized by exhibiting a liquid nature with a shear force applied thereto by a squeegee. Consequently, the solder paste can be filled in the opening of the mask. However, the solder paste, after being filled, comes into a standing state with no shear force applied thereto to thereby exhibit a solid nature again, and can therefore maintain a transferred shape.

As described above, the solder paste has solid and liquid natures as basic properties, and is therefore required to exhibit both the natures in the screen printing process. Smears occur with printing if the fluidity of the solder paste is too high, while there may raise the problem that a predetermined amount of the solder paste cannot be inserted into the opening if the solder paste is solid and too hard.

In addition, the process described above is repeated for multiple substrates in a process for mounting electronic components. Specifically, a process is repeated in which the solder paste receives a shear force applied by the squeegee and is then left standing. When the solder paste receives the shear force repeatedly, the viscoelastic property of the solder paste is degraded due to fatigue and its fluidity increases. Consequently, the problem of development of smears during screen printing and "shear drop" by heating or separation of a solder metal and a flux has raised. Since the screen printing process is usually carried out in air, the solder metal is repeatedly exposed to air. There is the problem that coherence and thickening easily occur due to oxidation of the solder metal and acceleration of reaction with a flux when the solder metal is exposed to air. Therefore, the solder paste is required to have an adequate tolerance to these problems. Particularly in recent years, improvement of mass productivity for mounted components has been required, and there has been increasing a demand for continuous use of a solder paste, in other words realization of a solder paste that can withstand long-time printing.

Conventionally, concerning an improvement in continuous printing characteristics of a solder paste, several measures have been proposed from the viewpoints of mainly prevention of oxidation of a solder metal and reaction with a flux. Specifically, a method of using, as a stabilizer, a compound having a triazole structure (Patent Document 1) and a method of using a polyhemiacetal ester resin (Patent Document 2) have been proposed. In addition, a method of covering the surface of a solder metal with an oxide film (Patent Document 3), a method of coating a solder metal powder with a polymer solution containing silicon (Patent Document 4) and the like have been proposed from the viewpoint of coverage and protection of the surface of a solder metal. Further, for improvement of reliability, a flux for soldering which has a rosin resin as a main component and uses a methacrylate or acrylate as a solvent (Patent Document 5) has been proposed. A solder paste composition for soldering of a circuit board, which uses a flux for a solder paste including an acrylic resin and a rosin resin (Patent Document 6) has been proposed as a solder paste composition for soldering of a circuit board, which does not suffer cracking in a flux residue even if used under an environment with a significant difference in temperature, and does not cause a short-circuit and corrosion of a circuit of a narrow-pitched print circuit board. In addition, a flux for cream solder which contains a copolymer having a rosin structure (Patent Document 7) has been proposed. Other fluxes for a solder paste are disclosed in JP2008110369 and WO2009/104693 A1.

However, according to the use of the stabilizer and coverage of a solder metal as described above, melting of a solder metal is considerably inhibited in a subsequent reflow process, and the soldering ability is therefore deteriorated. In addition, no effective measures have been found for ameliorating the fatigue-related degradation of a solder paste caused by a shear force received repeatedly during screen printing.

### PRIOR ART DOCUMENTS

### PATENT DOCUMENTS

Patent Document 1: Japanese Unexamined Patent Publication No. 2003-164992
Patent Document 2: Japanese Unexamined Patent Publication No. 2006-205203
Patent Document 3: Japanese Unexamined Patent Publication No. 2004-209494
Patent Document 4: Japanese Unexamined Patent Publication No. 2006-088205
Patent Document 5: Japanese Unexamined Patent Publication No. S61-199598
Patent Document 6: Japanese Unexamined Patent Publication No. 2001-150184
Patent Document 7: Japanese Unexamined Patent Publication No. 2008-110365

### SUMMARY OF THE INVENTION

### PROBLEMS TO BE SOLVED BY THE INVENTION

As described above, provision of a flux for a solder paste and a solder paste, which have adequate fluidity even if a shear force is applied repeatedly by, for example, a screen printing process, and suppresses fatigue-related degradation of the viscoelastic property and various kinds of performance degradation associated therewith, well meets market needs.

### SOLUTIONS TO THE PROBLEMS

The present invention solves the above technical problems to significantly contribute to realization of a flux and a solder paste well applicable to mass productivity of electronic circuit components, miniaturization of which has been significantly progressed in recent years. The inventors have conducted vigorous studies for providing a flux for a solder paste and a solder paste which achieve good printing characteristics. As a result, it has been found that an improvement in printing characteristics can be achieved by focusing on the mixing ratio of an acrylic resin and rosins contained in a flux and a solder paste and giving specific environments or conditions to the solder paste. The present invention has been created by way of such a viewpoint.

The flux for a solder paste of the present invention contains the features of claim 1.

The flux for a solder paste contributes to an improvement in continuous solder paste printing characteristics in mass production as fatigue-related degradation of the viscoelastic property is suppressed. A solder paste using the flux is fluidized under a specific shear force-applied environment during screen printing, and therefore fatigue-related degradation of its viscoelastic property can be suppressed. Therefore, there can be provided a solder paste excellent in that performance degradation can be suppressed even in long-time continuous printing. Consequently, there can be provided a flux and a solder paste well applicable to mass production of electronic circuit components, miniaturization of which has been significantly progressed.

### EFFECTS OF THE INVENTION

According to the flux for a solder paste of the present invention in accordance with claim 1 and the solder paste of the present invention in accordance with claim 3, continuous solder paste printing characteristics in mass production are improved. In addition, the above flux for a solder paste of the present invention and the above solder paste of the present invention are well applicable to mass production of electronic circuit components, miniaturization of which has been significantly progressed.

### BRIEF DESCRIPTION OF THE DRAWINGS

Fig. 1A is a schematic view showing one process of a step of coating a solder paste by a general screen printing process.
Fig. 1B is a schematic view showing one process of a step of coating a solder paste by a general screen printing process.
Fig. 1C is a schematic view showing one process of a step of coating a solder paste by a general screen printing process.
Fig. 1D is a schematic view showing one process of a step of coating a solder paste by a general screen printing process.
Fig. 2 is a graph showing the results of measuring the dynamic viscoelastic property of a solder paste in one embodiment of the present invention.

### DESCRIPTION OF SYMBOLS

10: substrate
12: electrode
14: mask plate for printing
16: solder paste
20: squeegee
30: electronic component

### MODES FOR CARRYING OUT THE INVENTION

An embodiment of the present invention will now be described.

### <First Embodiment>

In this embodiment, a representative composition of a flux for a solder paste according to claim 1 is described.

As described above, the flux for a solder paste of this embodiment contains an acrylic resin obtained by radically copolymerizing a (meth)acrylate having a C₆-C₁₅ alkyl group and a (meth)acrylate other than the above-mentioned (meth)acrylate; and rosins. Here, the flux for a solder paste of this embodiment has a weight ratio of the acrylic resin being 0.5 or greater and 1.2 or less when the weight of the rosins is taken as 1. If the weight ratio of the acrylic resin is less than 0.5, fatigue-related degradation may easily occur, since the solid nature as a solder paste is governing. On the other hand, if the weight ratio of the acrylic resin is greater than 1.2, fluidity may increase even in a standing state with no shear force applied, since the liquid nature as a solder paste is governing. As a result, the solder paste smears easily, thus raising the possibility of degrading printing characteristics and soldering ability.

In addition, the flux for a solder paste of this embodiment is fluidized by application of a shear force of 10 Pa or greater and 150 Pa or less. As a result, it has been found that for the solder paste containing the flux for a solder paste of this embodiment, printing characteristics and soldering ability of the solder paste in continuous screen printing in mass production are not degraded. For the flux for a solder paste of this embodiment, the solid nature is not governing, and therefore fatigue-related degradation of its viscoelastic property can be suppressed.

The flux for a solder paste of this embodiment contains the acrylic resin described above, and therefore the cracking resistance of residues can be improved. As described above, this acrylic resin is obtained by radically copolymerizing a (meth)acrylate having a C₆-C₁₅ alkyl group and a (meth)acrylate other than the above-mentioned (meth)acrylate. Here, representative examples of the (meth)acrylate having a C₆-C₁₅ alkyl group include hexyl (meth)acrylate, octyl (meth)acrylate, 2-ethylhexyl (meth)acrylate, isononyl (meth)acrylate, isobornyl (meth)acrylate, decyl (meth)acrylate, lauryl (meth)acrylate, myristyl (meth)acrylate and cyclohexyl (meth)acrylate. Representative examples of the (meth)acrylate other than the aforementioned (meth)acrylate include methyl (meth)acrylate, ethyl (meth)acrylate, butyl (meth)acrylate, n-propyl (meth)acrylate, isopropyl (meth)acrylate, n-butyl (meth)acrylate, isobutyl (meth)acrylate, t-butyl (meth)acrylate, isobornyl (meth)acrylate, methoxyethyl (meth)acrylate, ethoxyethyl (meth)acrylate, propoxyethyl (meth)acrylate, butoxyethyl (meth)acrylate, ethoxypropyl (meth)acrylate, phenyl (meth)acrylate, diethylaminoethyl (meth)acrylate, glycidyl (meth)acrylate and stearyl (meth)acrylate. In addition, representative radical polymerizations are a bulk polymerization process, a liquid polymerization process, a suspended polymerization process and an emulsion polymerization process using a radical polymerization initiator such as a peroxide as a catalyst, but other known polymerization processes can be applied.

Here, it is another preferred aspect that the acrylic resin has a weight average molecular weight of 6000 or greater and 12000 or less and a number average molecular weight of 4000 or greater and 6000 or less from the viewpoints of providing excellent cracking resistance and excellent viscoelastic property. The content of the acrylic resin contained in the flux for a solder paste of this embodiment is 15% by weight or greater and 30% by weight or less from the viewpoints of improvement of cracking resistance of flux residues and soldering ability.

Representative examples of the rosins described above are normal gum rosins, tall oil rosins and wood rosins. Representative examples of the derivatives of the rosin are resins obtained by heat treatment of a rosin, disproportionated rosins, polymerized rosins, hydrogenated rosins, formylated rosins, rosin esters, rosin modified maleic acid resins, rosin modified phenolic resins, acrylic acid addition rosins, rosin modified alkyd resins or the like. Such rosins and derivatives thereof can be a governing component which affects, as a base resin of a flux, the viscoelastic property of a flux and a solder paste using the same.

The rosins are at least one selected from the group consisting of an acrylic acid addition rosin, a disproportionated rosin, a polymerized rosin and a hydrogenated rosin from the viewpoints of controlling the viscoelastic property of a flux and a solder paste using the same and suppressing fatigue-related degradation during repeated application of a shear force along with the specific acrylic resin. The content of the rosins is 15% by weight or greater and 30% by weight or less as adequate hardness and deformability can be imparted and good soldering ability can be provided when the solder paste is used for screen printing. In addition to the aforementioned components, known components that can be used in preparation of a flux may be added to the flux of this embodiment. Specifically, known activators, polyolefins, waxes, solvents and the like can be used as an additive.

A method for producing a flux that is used for the solder paste of this embodiment will now be described.

The flux of this embodiment is obtained by, for example, dissolving or mixing an acrylic resin obtained by radically copolymerizing a (meth)acrylate having a C₆-C₁₅ alkyl group and a (meth)acrylate other than the above-mentioned (meth)acrylate (manufactured by Arakawa Chemical Industries, Ltd.: weight average molecular weight: about 9000, acid value: 0, glass transition temperature: -60°C), rosins (mixture of acrylic acid addition rosin, disproportionated rosin and polymerized rosin: manufactured by Arakawa Chemical Industries, Ltd.), diethylene glycol monohexyl ether (manufactured by Nippon Nyukazai Co., Ltd.), adipic acid (manufactured by Tokyo Chemical Industry Co., Ltd.), a dichlorobenzoic acid (manufactured by Tokyo Chemical Industry Co., Ltd.), an unsaturated fatty acid dimer (manufactured by Harima Chemicals, Inc.), a diphenylguanidine hydrobromide (manufactured by Nakao Yakuhin K.K.), a high-density polyethylene (manufactured by Mitsui Chemicals, Inc.), an ethylenebis 12 hydroxy stearic acid amide (manufactured by Nippon Kasei Chemical Company Limited) and a waxy product (manufactured by KYOEISHA CHEMICAL Co., Ltd.) by a known method.

Specifically, first, the above-mentioned components are heated at once or sequentially to be dissolved and/or mixed, and are thereafter cooled. Here, a known device such as a kneading device, a vacuum mixer, a homo dispenser, a Three-One motor, a planetary mixer or the like can be used as a device for dissolving or mixing the above-mentioned components. The temperature for mixing the above-mentioned components is not particularly limited. However, it is one preferred aspect that the above-mentioned components are dissolved by heating at temperature lower than the boiling point of a solvent used in mixing. Other known processes for producing a flux can also be applied for this embodiment.

### <Second Embodiment>

In this embodiment, the representative composition of a solder paste is according to claim 3.

First, for the solder paste of this embodiment, a solder powder having a composition ratio of tin: 96.5% by weight, silver: 3.0% by weight and copper: 0.5% by weight was used. The values described above refer to the weight ratio of each metal.

The solder paste of this embodiment can be produced by blending one or more fluxes for a solder paste of this embodiment including the preferred aspects disclosed in First Embodiment and the solder powder by known means. Specifically, a known device such as a vacuum mixer, a kneading device, a planetary mixer or the like can be used as a device for blending the above-mentioned components. Here, the treatment temperature and conditions in blending are not particularly limited for the production method of this embodiment. However, it is preferable that the treatment be carried out at 5°C or higher and 50°C or lower from the viewpoints of absorption of water from an external environment, oxidation of solder metal particles, thermal degradation of the flux due to temperature rising and the like. The weight ratio of the flux and the solder powder is not particularly limited for the production method of this embodiment. However, it is preferable that the weight ratio of the flux be 5 or greater and 20 or less while the weight ratio of the solder powder be 80 or greater and 95 or less from the viewpoints of printing workability and stability of a paste.

One or more materials selected from the group consisting of an antioxidant, a delustering agent, a colorant, a defoaming agent, a dispersion stabilizer, a chelating agent and the like can be further appropriately blended in the solder paste of this embodiment as necessary within the range of not impairing the effect of this embodiment.

Incidentally, the composition of a solder powder that is used for the solder paste of this embodiment is not particularly limited to that of the above-mentioned solder powder. Specifically, one example thereof includes a solder powder containing one or more selected from the group consisting of tin (Sn), copper (Cu), zinc (Zn), silver (Ag), antimony (Sb), lead (Pb), indium (In), bismuth (Bi), nickel (Ni), aluminum (Al), gold (Au) and germanium (Ge). Another example includes a solder powder containing one or more selected from the group consisting of a known tin/lead alloy, a tin/silver alloy, a tin/silver/copper alloy, tin/silver/bismuth/indium, a tin/copper alloy, tin/copper/nickel, a tin/zinc alloy, a tin/zinc/bismuth alloy, a tin/zinc/aluminum alloy, a tin/zinc/bismuth/aluminum alloy, a tin/zinc/bismuth/indium alloy, a tin/bismuth alloy and a tin/indium alloy.

The shape of the solder powder is preferably spherical or substantially spherical. The solder powder can be mixed with the flux disclosed in First Embodiment as long as its particle size is a normal size. For example, when a spherical solder powder is employed, employment of a solder powder with a diameter in the range of 5 µm or greater and 60 µm or less is preferable from the viewpoint of increasing the accuracy of mounting of microelectronic components. The composition ratio of components constituting the solder powder is not particularly limited. For example, one preferred example of the solder powder includes Sn 63/Pb 37, Sn 96.5/Ag 3.5, Sn 96/Ag 3.5/Cu 0.5, Sn 96.6/Ag 2.9/Cu 0.5, Sn 96.5/Ag 3.0/Cu 0.5 or the like. The values described above refer to the weight ratio of each metal.

As previously described, the solder paste of this embodiment produced by the above-mentioned method is very excellent in continuous solder paste printing characteristics in mass production. It is one preferred aspect that the solder paste of this embodiment has a modulus of 1000 Pa or greater and 100000 Pa or less at normal temperature as adequate hardness and deformability can be imparted when the solder paste is used in screen printing.

In production of the solder paste of this embodiment, a solvent may be used as required. The type of the solvent is not particularly limited. However, employment of a solvent with a boiling point of 150°C or higher is preferable in that the solvent is hard to be vaporized during production of the solder paste. Specific examples thereof include triethylene glycol monomethyl ether, triethylene glycol dimethyl ether, tetraethylene glycol dimethyl ether, diethylene glycol monomethyl ether, diethylene glycol monobutyl ether, diethylene glycol monohexyl ether, ethylene glycol monophenyl ether, diethylene glycol monophenyl ether, diethylene glycol monobutyl acetate, dipropylene glycol, diethylene glycol-2-ethylhexyl ether, α-terpineol, benzyl alcohol, 2-hexyl decanol, butyl benzoate, diethyl adipate, diethyl phthalate, dodecane, tetradecene, dodecyl benzene, ethylene glycol, diethylene glycol, dipropylene glycol, triethylene glycol, hexylene glycol, 1,5-pentanediol, methyl carbitol and butyl carbitol. Preferably, examples of the solvent include triethylene glycol dimethyl ether, tetraethylene glycol dimethyl ether and diethylene glycol monobutyl acetate.

One preferred example of the solvent used in this embodiment is a polar solvent that easily dissolves components such as an activator and a resin to form a solution. Typically, an alcohol solvent is used and particularly, diethylene glycol monoethers are excellent in volatility and activator solubility. When the aforementioned solvent is used, the amount of the solvent to be used is not particularly limited. However, it is preferable that the solvent be present in an amount of 15 parts by weight or greater and 40 parts by weight or less based on 100 parts by weight of the flux from the viewpoints of printing workability and stability of a paste. However, when multiple solvents are used in combination, the total amount of those solvents preferably falls within the range described above. From the aforementioned viewpoints, it is further preferable that the solvent be present in an amount of 20 parts by weight or greater and 35 parts by weight or less.

The above embodiments will be described further in detail below by way of examples.

### [Example 1]

First, 11 parts by weight of a flux for a solder paste prepared using the components listed in Table 1 and 89 parts by weight of a solder powder (tin: 96.5% by weight, silver: 3.0% by weight, copper: 0.5% by weight) with a particle size distribution corresponding to Type 4 in the IPC standard were mixed using a planetary mixer to thereby prepare a solder paste. The high-density polyethylene used in preparation of the flux for a solder paste had an average particle size of about 20 µm, a molar weight of viscosity of about 3000, a melting point of 120°C, an acid value of 0 and a glass transition temperature of -50°C. The acrylic resin had a weight average molecular weight of about 9000, an acid value of 0 and a glass transition temperature of -60°C.

The dynamic viscoelastic property at room temperature (25°C) was measured using the solder paste of Example 1 (using MARS manufactured by Haake Ins. Co.). The specific measurement method is as follows:
(1) a solder paste (sample) is first inserted so that the gap size is 0.5 mm using a titanium parallel flat plate with a diameter of 20 mm,
(2) a shear stress is then applied to the sample with sweeping from 3 Pa to 3000 Pa at a frequency of 0.5 Hz, and
(3) the storage elastic modulus and the loss elastic modulus are measured when the shear stress of (2) is applied.

In Example 1, a point at which the storage elastic modulus and the loss elastic modulus measured as described above are equal is designated as a fluidization point at which a solid substance is changed into a liquid substance at the time of application of an extremely low shear stress.

Further, a continuous rolling (squeegeeing) test was carried out for 4 hours for the solder paste (sample) of Example 1. Specifically, polyurethane rubber squeegee (hardness 90) was used to squeegee the sample continuously for 4 hours under conditions of a squeegee angle of 60°, a printing tact of 30 seconds and a stroke of 300 mm. The input of the sample was 500 g. For the post-continuous rolling sample obtained in this way, the dynamic viscoelastic property was measured in the same manner as described above.

### [Example 2]

A solder paste of Example 2 is produced in the same manner as in Example 1. The solder paste of Example 2 is same as that in Example 1 except that the composition ratios of the acrylic resin and the rosins of the flux for a solder paste are different from those in Example 1. Therefore, duplicate descriptions are omitted.

### [Example 3]

A solder paste of Example 3 is produced in the same manner as in Example 1. The solder paste of Example 3 is same as that in Example 1 except that the composition ratios of the acrylic resin and the rosins of the flux for a solder paste are different from those in Example 1. Therefore, duplicate descriptions are omitted.

### [Example 4]

A solder paste of Example 4 is produced in the same manner as in Example 1. The solder paste of Example 4 is same as that in Example 1 except that the composition ratios of the acrylic resin and the rosins of the flux for a solder paste are different from those in Example 1. Therefore, duplicate descriptions are omitted.

### [Comparative Example 1]

A solder paste of Comparative Example 1 is produced in the same manner as in Example 1. The solder paste of Comparative Example 1 is same as that in Example 1 except that the composition ratios of the acrylic resin and the rosins of the flux for a solder paste are different from those in Example 1. Therefore, duplicate descriptions are omitted.

### [Comparative Example 2]

A solder paste of Comparative Example 2 is produced in the same manner as in Example 1. The solder paste of Comparative Example 2 is same as that in Example 1 except that the composition ratios of the acrylic resin and the rosins of the flux for a solder paste are different from those in Example 1. Therefore, duplicate descriptions are omitted.

**[Table 1]**

| Composition | Example 1 weight (%) | Example 2 weight (%) | Example 3 weight (%) | Example 4 weight (%) | Comparative Example 1 weight (%) | Comparative Example 2 weight (%) |
|---|---|---|---|---|---|---|
| Acrylic resin | 26.0 | 18 | 28.0 | 22 | 12 | 40 |
| Rosins | 26.0 | 34 | 24.0 | 30 | 40 | 12 |
| Diethylene glycol monohexyl ether | 28.5 | 28.5 | 28.5 | 28.5 | 28.5 | 28.5 |
| Adipic acid | 3.0 | 3.0 | 3.0 | 3.0 | 3.0 | 3.0 |
| Dichloro benzoic acid | 3.0 | 3.0 | 3.0 | 3.0 | 3.0 | 3.0 |
| Unsaturated fatty acid dimer | 3.0 | 3.0 | 3.0 | 3.0 | 3.0 | 3.0 |
| Diphenylguanidine hydrobromide | 0.5 | 0.5 | 0.5 | 0.5 | 0.5 | 0.5 |
| Ethylenebis 12 hydroxystearic acid amide | 2.0 | 2.0 | 2.0 | 2.0 | 2.0 | 2.0 |
| High-density polyethylene | 7.0 | 7.0 | 7.0 | 7.0 | 7.0 | 7.0 |
| Waxy product | 1.0 | 1.0 | 1.0 | 1.0 | 1.0 | 1.0 |
| Total | 100.0 | 100.0 | 100.0 | 100.0 | 100.0 | 100.0 |

**[Table 2]**

| | Example 1 | Example 2 | Example 3 | Example 4 | Comparative Example 1 | Comparative Example 2 |
|---|---|---|---|---|---|---|
| Initial fluidization point | 59.6 Pa | 120.3 Pa | 45.5 Pa | 101.7 Pa | 182.0 Pa | None |
| Initial modulus | 4950 Pa | 12600 Pa | 3520 Pa | 8900 Pa | 14400 Pa | 2300 Pa |
| Fluidization point after 4-hour rolling | 80.5 Pa | 145.3 Pa | 63.5 Pa | 132.4 Pa | 332 Pa | None |
| Modulus after 4-hour rolling | 7570 Pa | 18100 Pa | 5620 Pa | 13940 Pa | 33400 Pa | 2150 Pa |

**[Table 3]**

| | Example 1 | Example 2 | Example 3 | Example 4 | Comparative Example 1 | Comparative Example 2 |
|---|---|---|---|---|---|---|
| Initial wettability | ○ | ○ | ○ | ○ | ○ | Δ |
| Initial solder ball | ○ | ○ | ○ | ○ | ○ | × |
| Initial slump | ○ | ○ | ○ | ○ | ○ | × |
| Initial printing characteristics | ○ | ○ | ○ | ○ | × | Δ |
| Wettability after 4-hour rolling | ○ | ○ | ○ | ○ | Δ | × |
| Solder ball after 4-hour rolling | ○ | ○ | ○ | ○ | Δ | × |
| Slump after 4-hour rolling | ○ | ○ | ○ | ○ | Δ | × |
| Printing characteristics after 4-hour rolling | ○ | ○ | ○ | ○ | × | Δ |

Fig. 2 is a graph showing the results of measuring the dynamic viscoelastic property of the solder paste (hereinafter also referred to as sample 1A) in Example 1. Table 2 is a table plainly showing the results of measuring the dynamic viscoelastic properties of the solder pastes of Examples 1 to 4 and Comparative Examples 1 and 2. Table 3 is a table plainly showing the values in performance of Examples 1 to 4 and Comparative Examples 1 and 2.

As shown in Fig. 2 and Table 2, at the beginning (hereinafter also referred to as initial stage) of production of the sample 1A of Example 1, the storage elastic modulus was 4950 Pa when a shear stress of 9.9 Pa was applied. The storage elastic modulus at that time is greater than the loss elastic modulus, and therefore it can be determined that the sample 1A is a solid substance. However, when a shear stress of 59.6 Pa was applied to the sample 1A, the values of the storage elastic modulus and the loss elastic modulus were equal (1176 Pa), and therefore it can be determined that this shear stress value is a starting point of fluxion.

Next, the above-mentioned continuous rolling (squeegeeing) test was carried out for 4 hours for the sample 1A. As a result, for the solder paste undergoing the continuous rolling test (hereinafter also referred to as sample 1B), the storage elastic modulus was 7570 Pa when a shear stress of 9.9 Pa was applied. The storage elastic modulus at that time is greater than the loss elastic modulus, and therefore it can be determined that the sample 1B is a solid substance. However, when a shear stress of 80.5 Pa was applied to the sample 1B, the values of the storage elastic modulus and the loss elastic modulus were equal (1228 Pa), and therefore it can be determined that this shear stress value is a starting point of fluxion.

As described above, when comparing the sample 1A with the sample 1B, the starting point of fluxion is more or less shifted to the high shear stress side, but the shift amount (hereinafter also referred to as S value) is only 100 Pa or less. That is, the solder paste of Example 1 is shown to have a very small variation in viscoelastic property, i.e. contain a flux with suppressed fatigue-related degradation. Thus, it has become evident that by using the solder flux of Example 1, degradations of continuous solder paste printing characteristics and soldering ability are well suppressed.

Next, the dynamic viscoelastic property for each of the solder pastes of Examples 2 to 4 was measured in the same manner as in Example 1. As a result, any solder paste of Examples 2 to 4 was shown to have a very small variation in viscoelastic property, i.e. contain a flux with suppressed fatigue-related degradation like the solder paste of Example 1. Thus, it has become evident that by using any solder flux of Examples 2 to 4, degradations of continuous solder paste printing characteristics and soldering ability are well suppressed. On the other hand, for the solder paste of Comparative Example 1, the S value was 100 Pa or greater. Thus, the solder paste of Comparative Example 1 was found to be poor in continuous solder paste printing characteristics and soldering ability in mass production as it had a large variation in viscoelastic property, i.e. contained a flux which causes fatigue-related degradation. For the solder paste of Comparative Example 2, the storage modulus was already less than the loss modulus in an initial state before the continuous rolling, in other word there was no S value. At this time, the solder paste of Comparative Example 2 had a liquid nature of high fluidity and maintained high fluidity even after 4-hour continuous rolling. Therefore, such a substance having high fluidity is not favorable as a solder paste that is used in screen printing as the paste transferred on a substrate cannot maintain its shape.

In addition, as a result of examining properties related to "wettability", "solder ball", "slumping resistance" and "printing characteristics" for the solder pastes of Examples 1 to 4 and two comparative examples, good properties were obtained either in an initial stage or after 4 hours for the solder pastes of Examples 1 to 4 as shown in Table 3. On the other hand, for Comparative Examples 1 and 2, unfavorable results were obtained from the viewpoints of soldering ability and mass production applicability that are fundamental properties, concerning at least one of the aforementioned various properties.

Incidentally, in the embodiments and examples described above, high-density polyethylene is contained in the flux or the solder paste as a resin additive. Here, it is one preferred aspect that the high-density polyethylene meets at least one of the following requirements a) to d) for the particle size, particle size distribution or shape of particulate high-density polyethylenes.
a) The high-density polyethylenes have an average of the longest particle sizes of 0.001 µm or greater and 50 µm or less.
b) The number of high-density polyethylenes with the longest particle size of 60 µm or less within a randomly selected field of 1.5 mm × 1.1 mm in the flux for a solder paste is 90% or greater of the total number of the high-density polyethylenes when observed at a 200X magnification by a light microscope.
c) The number of high-density polyethylenes with the longest particle size of 100 µm or greater within a randomly selected field of 3.1 mm × 2.3 mm in the flux for a solder paste is 1% or less of the total number of the high-density polyethylenes when observed at a 100X magnification by a light microscope.
d) The high-density polyethylene has a polyhedron shape.

The slumping resistance is improved by meeting the requirements. Thus, for example, accuracy is increased with which the high-density polyethylene within the flux or the solder paste is placed on a miniaturized electrode or the like, and therefore applicability to electronic circuit components and the like is further improved. Many high-density polyethylenes have a polyhedron shape. It is more preferable to meet two or more of the requirements a) to d) at the same time, and it is further preferable to meet all the requirements at the same time.

It is one preferred aspect that the high-density polyethylene has a molar weight of viscosity of 1500 or greater and 4500 or less. If this range of molar weight of viscosity is met, the effect of suppression of "shear drop" during heating is further improved.

It is another preferred aspect that the high-density polyethylene has a melting point of 110°C or higher and 130°C or lower. If this range of melting point is met, the effect of suppression of "shear drop" during heating is further improved.

It is another preferred aspect that the high-density polyethylene has an acid value of 1 or less. If this range of acid value is met, reduction of insulation reliability by addition of the high-density polyethylene can be prevented.

In addition, it is another preferred aspect that the high-density polyethylene has a glass transition temperature of -50°C or lower. If this range of glass transition temperature is met, deterioration of the clacking resistance of flux residues, which is required particularly for a paste for an on-vehicle electronic component, can be suppressed.

Even if polypropylene is contained in place of the high-density polyethylene, at least part of effects of the embodiments and the examples described above can be exhibited. It is one preferred aspect that the polypropylene meets at least one of the following requirements a) to d) for the particle size, particle size distribution or shape of particulate polypropylenes.
a) The polypropylene has an average of the longest particle sizes of 0.001 µm or greater and 50 µm or less.
b) The number of polypropylene with a longest particle size of 60 µm or less within a randomly selected field of 1.5 mm × 1.1 mm in the flux for a solder paste is 90% or greater of the total number of the polypropylene when observed at a 200X magnification by a light microscope.
c) The number of polypropylene with a longest particle size of 100 µm or greater within a randomly selected field of 3.1 mm × 2.3 mm in the flux for a solder paste is 1% or less of the total number of the polypropylene when observed at a 100X magnification by a light microscope.
d) The polypropylene has a polyhedron shape.

The slumping resistance is improved by meeting the requirements. Thus, for example, accuracy is increased with which the polypropylene within the flux or the solder paste is placed on a miniaturized electrode or the like, and therefore applicability to electronic circuit components and the like is further improved.

It is one preferred aspect that the polypropylene has a molar weight of viscosity of 5000 or greater and 20000 or less. If this range of molar weight of viscosity is met, the effect of suppression of "shear drop" during heating is further improved.

It is another preferred aspect that the polypropylene has a melting point of 130°C or higher and 160°C or lower. If this range of melting point is met, the effect of suppression of "shear drop" during heating is further improved.

It is another preferred aspect that the polypropylene has an acid value of 1 or less. If this range of acid value is met, reduction of insulation reliability by addition of the polypropylene can be prevented.

In addition, it is another preferred aspect that the polypropylene has a glass transition temperature of 0°C or lower. If this range of glass transition temperature is met, deterioration of the clacking resistance of flux residues, which is required particularly for a paste for an on-vehicle electronic component, can be suppressed.

Further, not only a flux for a solder paste including only one of the high-density polyethylene and the polypropylene but also a flux for a solder paste including both thereof is one preferred aspect from the viewpoint of improving applicability to miniaturization of electronic circuit components and the like.

In addition, it is other preferred aspects that the solder paste containing the high-density polyethylene and/or the polypropylene further include a waxy product being obtained by dehydration reaction of a higher aliphatic monocarboxylic acid, a polycarboxylic acid and diamine and having a melting point of 100°C or higher. This waxy product can help the action of the high-density polyethylene or polypropylene described above.

### INDUSTRIAL APPLICABILITY

The flux for a solder paste and solder paste of the present invention are very useful for solder bonding in various applications such as electronic circuit components.

## Claims

1. A flux for a solder paste, comprising
an acrylic resin obtained by radically copolymerizing a (meth)acrylate having a C₆-C₁₅ alkyl group and a (meth)acrylate other than the above-mentioned (meth)acrylate; and rosins,
wherein the rosins are at least one selected from the group consisting of an acrylic acid addition rosin, a disproportionated rosin, a polymerized rosin and a hydrogenated rosin;
**characterized in that**
the content of the acrylic resin is 15% by weight or greater and 30% by weight or less;
the content of the rosins is 15% by weight or greater and 30% by weight or less;
the weight ratio of the acrylic resin is 0.5 or greater and 1.2 or less when the weight of the rosins is taken as 1; and the flux for a solder paste is fluidized by application of a shear force of 10 Pa or greater and 150 Pa or less.

2. The flux for a solder paste according to claim 1, wherein the acrylic resin has a weight average molecular weight of 6.000 or greater and 12.000 or less and a number average molecular weight of 4.000 or greater and 6.000 or less.

3. A solder paste comprising the flux for a solder paste according to claim 1 or 2.

4. The solder paste according to claim 3, having a modulus of 1.000 Pa or greater and 100.000 Pa or less at normal temperature.

## Patentansprüche

1. Flussmittel für eine Lötpaste, das
ein Acrylharz erhalten durch radikalisches Copolymerisieren eines (Meth)acrylats mit einer C₆-C₁₅-Alkygruppe und einem anderen als dem zuvor genannten (Meth)acrylat; und Naturharze umfasst,
wobei die Naturharze mindestens eines ausgewählt aus der Gruppe bestehend aus Akrylsäureadditionsnaturharz, disproportioniertem Naturharz, polymerisiertem Naturharz und hydriertem Naturharz sind,
dadurch charakterisiert, dass
der Anteil des Akrylharzes 15 Gewichts% oder mehr und 30 Gewichts% oder weniger ist;
der Anteil der Naturharze 15 Gewichts% oder mehr und 30 Gewichts% oder weniger ist;
das Gewichtsverhältnis des Akrylharzes 0,5 oder mehr und 1,2 oder weniger ist, wenn das Gewicht der Naturharze als 1 genommen wird;
und
das Flussmittel für eine Lötpaste durch die Anwendung einer Schubkraft von 10 Pa oder mehr und 150 Pa oder weniger verflüssigt wird.

2. Flussmittel für eine Lötpaste nach Anspruch 1, wobei das Akrylharz ein Gewichtsmittel des Molekulargewichts von 6.000 oder mehr und 12.000 oder weniger und ein Zahlenmittel des Molekulargewichts von 4.000 oder mehr und 6.000 oder weniger aufweist.

3. Lötpaste, die das Flussmittel für eine Lötpaste nach Anspruch 1 oder 2 umfasst.

4. Lötpaste nach Anspruch 3, die ein Modul von 1.000 Pa oder mehr und 100.000 Pa oder weniger bei Raumtemperatur aufweist.

## Revendications

1. Flux pour pâte à braser, comprenant
une résine acrylique obtenue par copolymérisation radicale d'un (méth)acrylate comportant un groupe alkyle *C*₆ - *C*₁₅ et un (méth)acrylate autre que le (méth)acrylate indiqué ci-dessus ; et des colophanes,
dans lequel les colophanes sont au moins une colophane choisie dans le groupe constitué d'une colophane à addition d'acide acrylique, une colophane disproportionnée, une colophane polymérisée et une colophane hydrogénée ;
**caractérisé en ce que**
la teneur de la résine acrylique est de 15 % en poids ou plus et de 30 % en poids ou moins ;
la teneur des colophanes est de 15 % en poids ou plus et de 30 % en poids ou moins ;
le rapport en poids de la résine acrylique est de 0,5 ou plus et de 1,2 ou moins lorsque le poids des colophanes est pris comme valeur 1 ;
et
le flux pour pâte à braser est fluidifié par application d'une force de cisaillement de 10 Pa ou plus et de 150 Pa ou moins.

2. Flux pour pâte à braser suivant la revendication 1, dans lequel la résine acrylique a une masse moléculaire moyenne en poids de 6.000 ou plus et de 12.000 ou moins et une masse moléculaire moyenne en nombre de 4.000 ou plus et de 6.000 ou moins.

3. Pâte à braser comprenant le flux pour pâte à braser suivant la revendication 1 ou 2.

4. Pâte à braser suivant la revendication 3, ayant un module de 1.000 Pa ou plus et de 100.000 Pa ou moins à température normale.
